# EUROPEAN PATENT APPLICATION

(11) **EP 2 244 285 A1**
(43) Date of publication of application: **27.10.2010**
(21) Application number: 09158715.4
(22) Date of filing: 24.04.2009
(51) Int. Cl.: H01L 21/48, H05K 3/34

(54) **Method to form solder deposits on substrates**

(71) Applicant: ATOTECH Deutschland GmbH, 10553 Berlin (DE)
(72) Inventor: Lamprecht, Sven, 16727, Oberkrämer/Eichstädt (DE); Matejat, Kai-Jens, 14109, Berlin (DE); Ewert, Ingo, 14167, Berlin (DE)
(74) Representative: Wonnemann, Jörg

(57) **Abstract**

Described is a method of forming a solder deposit on a substrate comprising the following steps i) provide a substrate including a surface bearing electrical circuitry that includes at least one inner layer contact pad, ii) form a solder mask layer that is placed on the substrate surface and patterned to expose the at least one contact area, iii) contact the entire substrate area including the solder mask layer and the at least one contact area with a solution suitable to provide a conductive layer on the substrate surface, iv) electroplate a solder deposit layer containing a tin or tin alloy onto the conductive layer and v) etch away an amount of the solder deposit layer containing tin or tin alloy sufficient to remove the solder deposit layer from the solder mask layer area leaving a solder material layer on the at least one contact area.

## Description

### Field of the Disclosure

The invention relates to the formation of solder deposits by electroplating, particularly to flip chip packages, more particularly to flip chip C4 solder joints and IC substrate BGA side to board solder joints formed by electroplated solder of tin and tin alloys.

### Background of the Invention

Since the introduction of the flip chip technology by IBM in the early 1960s, the flip chip devices have been mounted on an expensive ceramic substrate where the thermal expansion mismatch between the silicon chip and the ceramic substrate is less critical. In comparison with wire bonding technology, the flip chip technology is better able to offer higher packaging density (lower device profile) and higher electrical performance (shorter possible leads and lower inductance). On this basis, the flip chip technology has been industrially practiced for the past 40 years using high-temperature solder (controlled-collapse chip connection, C4) on ceramic substrates. However, in recent years, driven by the demand of high-density, high-speed and low-cost semiconductor devices for the trend of miniaturization of modern electronic products, the flip chip devices mounted on a low-cost organic circuit board (e.g. printed circuit board or substrate) with an epoxy underfill to mitigate the thermal stress induced by the thermal expansion mismatch between the silicon chip and organic board structure have experienced an obviously explosive growth. This notable event of low-temperature flip chip joints and organic-based circuit board has enabled the current industry to obtain inexpensive solutions for fabrication of flip chip devices.

In the current low-cost flip chip technology, the top surface of the semiconductor integrated circuit (IC) chip has an array of electrical contact pads. The organic circuit board has also a corresponding grid of contacts. The low-temperature solder bumps or other conductive adhesive material are placed and properly aligned in between the chip and circuit board. The chip is flipped upside down and mounted on the circuit board, in which the solder bumps or conductive adhesive material provide electrical input/output (I/O) and mechanical interconnects between the chip and circuit board. For solder bump joints, an organic underfill encapsulant may be further dispensed into the gap between the chip and circuit board to constrain the thermal mismatch and lower the stress on the solder joints.

In general, for achieving a flip chip assembly by solder joints, the metal bumps, such as solder bumps, gold bumps or copper bumps, are commonly pre-formed on the pad electrode surface of the chip, in which the bumps can be any shape, such as stud bumps, ball bumps, columnar bumps, or others. The corresponding solder bumps (or say presolder bumps), typically using a low-temperature solder, are also formed on the contact areas of the circuit board. At a reflow temperature, the chip is bonded to the circuit board by means of the solder joints. After dispensing of an underfill encapsulant, the flip chip device is thus constructed. Such methods are well known in the art and typical examples of the flip chip devices using solder joints are for example described in U.S. Pat. No 7,098,126 (H.-K. Hsieh et al.).

Currently, the most common method for formation of presolder bumps on the circuit board is the stencil printing method. Some prior proposals in relation to the stencil printing method can be referred to U.S. Pat. No. 5,203,075 (C. G. Angulas et al.), U.S. Pat. No. 5,492,266 (K. G. Hoebener et al.) and U.S. Pat. No. 5,828,128 (Y. Higashiguchi et al.). Solder bumping technique for flip chip assemblies requires design considerations regarding both bump pitch and size miniaturization. According to practical experiences, the stencil printing will become infeasible once the bump pitch is decreased below 0.15 millimeter. In contrast, the solder bumps deposited by electroplating offer the ability to further reduce bump pitch down to below 0.15 millimeter. The prior proposals in relation to electroplate bumps on the circuit board for flip chip bonding can be found in U.S. Pat. No. 5,391,514 (T. P. Gall et al.) and U.S. Pat. No. 5,480,835 (K. G. Hoebener et al.). Although electroplate solder bumping on the circuit board offers finer bump pitch over stencil printing, it presents several challenges for initial implementation.

A multi-step process to form solder on an organic substrate is described in U.S. Pat. No. 7,098,126 (H.-K. Hsieh et al.). In the method, there is initially provided an organic circuit board including a surface bearing electrical circuitry that includes at least one contact area. A solder mask layer that is placed on the board surface and patterned to expose the pad. Subsequently, a metal seed layer is deposited by physical vapor deposition, chemical vapor deposition, electroless plating with the use of catalytic copper, or electroplating with the use of catalytic copper, over the board surface. A resist layer with at least an opening located at the pad is formed over the metal seed layer. A solder material is then formed in the opening by electroplating. Finally, the resist and the metal seed layer beneath the resist are removed. To apply this method various patterning steps are required which is not desired from the overall standpoint of process efficiency. Furthermore the method has its limitations if the distance between adjacent contact areas (pitch) is very small as a result of the miniaturization of electronic devices.

A fabrication method of conductive bump structures of circuit boards is disclosed in US 2006/0219567 A1. A solder material is electroplated onto the substrate which is partially protected by a solder mask followed by deposition of an etch resist onto the layer of solder material which is then patterned in a way that the solder material coated connecting pads are protected during the following etching step. Solder material which is not needed for the solder depots is then etched away leaving only the etch resist protected solder depot above the connecting pads.

Accordingly, it is the aim of the present invention to provide a method for forming solder deposits on substrates like circuit boards, which involves a reduced number of process steps. Furthermore, it is the aim to offer a plating method yielding solder material of high uniformity which is suitable to form solder deposits on very fine structures also.

### Summary of the Disclosure

It is therefore an objective of the present invention to adopt an electroplating method of tin and tin alloys to produce a uniform layer of a solder deposit on a substrate. Such a method should be suitable to fill recess structures possessing high aspect ratios without leaving voids or dimples.

Another object of the present invention is to provide a method for solder deposition having a reduced number of plating steps and which is universally applicable even when the solder resist openings have different dimensions.

Another objective of the present invention is to provide a method to form a metal seed layer on a non-conductive substrate, e.g. a printed circuit, which is used to produce electroplate solder for forming flip chip solder joints and board to board solder joints.

In summary, a method of fabricating electroplate solder deposits on a substrate for forming flip chip solder joints and board to board solder joints is disclosed. According to the present invention, there is provided a non-conductive substrate like a circuit board including a surface bearing electrical circuitry which includes at least one contact area. Such contact area can be any conductive surface area, e.g. a contact pad or the topmost area of a circuitry facing outside the substrate.

After applying a solder mask on part of the surface of the substrate a conductive seed layer is formed on the entire surface area. Optionally, prior to the deposition of the seed layer the solder mask layer can be enhanced in height by an additional non-conductive layer, e.g. a resist. This results in an increased volume of the subsequently plated solder deposit. A solder material layer containing a tin or tin alloy onto the conductive layer is then plated on the conductive areas of the substrate to form a solder deposit. Thereafter, excess solder material is etched away in an amount sufficient to remove the solder material from the solder mask layer area leaving a solder deposit on the at least one contact area to form a solder deposit. Also removed, preferably in the same process step, is the conductive seed layer from the solder mask layer area.

Another objective of the present invention is to provide a method of fabricating electroplate solder deposits on a substrate for forming flip chip solder joints and board to board solder joints whereon optionally an electrical circuitry is formed by a print and etch process: at least one hole is drilled down to an inner layer contact pad and said hole is treated with a desmear process. A solder mask is deposited on said circuitry and patterned that the at least one drilled hole is not covered by said solder mask.

In another embodiment, a solder mask is deposited onto an electrical circuitry formed by a print and etch process on a non-conductive substrate. At least one hole is drilled through said solder mask down to an inner layer contact pad and said hole is treated with a desmear process.

Next, a conductive seed layer is formed on the entire surface area. Optionally, prior to the deposition of the seed layer the solder mask layer can be enhanced in height by an additional non-conductive layer, e.g. a resist. This results in an increased volume of the subsequently plated solder deposit. Optionally, prior to the deposition of the seed layer a diffusion barrier can be deposited. A solder material layer containing a tin or tin alloy onto the conductive layer is then plated on the conductive areas of the substrate to form a solder deposit. Thereafter, excess solder material is etched away in an amount sufficient to remove the solder material from the solder mask layer area leaving a solder deposit on the at least one contact area to form a solder deposit. Also removed, preferably in the same process step, is the conductive seed layer from the solder mask layer area.

Optionally, an additional layer of a metal or metal alloy is deposited onto the solder deposit after excess solder material is etched away. The metal or metal alloy is deposited by an electroless process and is selected from the group consisting of lead, silver, copper, bismuth, antimony, zinc, nickel, aluminium, magnesium, indium, tellurium, gold and gallium.

### Brief Description of the Drawings

Fig. 1 shows a method to obtain a solder mask defined pad with a blind micro via (BMV) possessing a planarized electroplated solder material layer.
Fig. 2 shows a method to obtain a solder mask defined pad with a blind micro via (BMV) possessing a planarized electroplated solder material layer and a diffusion barrier.
Fig. 3 shows a method to obtain a solder mask defined pad with stacked blind micro vias (BMV) possessing a planarized electroplated solder material layer.
Fig. 4 shows a method to obtain a solder mask defined pad with a planarized electroplated solder material layer and a diffusion barrier.
Fig. 5 shows a method to obtain a non-solder mask defined pad with a planarized electroplated solder material layer and a diffusion barrier.
Fig. 6 shows a method to obtain a solder mask defined pad with a blind micro via (BMV) possessing a planarized electroplated solder material layer and a diffusion barrier.
Fig. 7 shows a method to obtain a non-solder mask defined pad with a blind micro via (BMV) possessing a planarized electroplated solder material layer and a diffusion barrier.
Fig. 8 shows a method to obtain a solder mask defined pad with individual heights of the electroplated solder material layer and a diffusion barrier, which is subjected to a reflow process.
Fig. 9 shows a method to obtain a non-solder mask defined pad with individual heights of the electroplated solder material layer and a diffusion barrier, which is subjected to a reflow process.
Fig. 10 shows a method to obtain a solder mask defined pad with a blind micro via (BMV) possessing electroplated solder material layers of individual heights and a diffusion barrier, subjected to a reflow process.
Fig. 11 shows a method to obtain a non-solder mask defined pad with a blind micro via (BMV) possessing electroplated solder material layers of individual heights and a diffusion barrier, subjected to a reflow process.
Fig. 12 shows a method to obtain a non-solder mask defined pad with individual heights of the electroplated solder material layer and a diffusion barrier, applying an additional resist to increase the volume of the solder deposit.
Fig. 13 shows joining of a planar structure according to the embodiment of Fig. 4 with an embodiment of Fig. 10 containing additional solder volume (solder bump).
Fig. 14 shows joining of a planar structure according to the embodiment of Fig. 4 with an embodiment of Fig. 7 containing additional solder volume having a pre-balled structure obtained by reflowing the solder (solder bump).

- 101: copper layer
- 102: structured copper layer
- 103: solder resist opening (SRO)
- 104: inner layer contact pad
- 105: non-conductive substrate
- 106: solder mask layer
- 107: conductive seed layer
- 108: optional barrier layer
- 109: solder deposit layer
- 110: opening, formed BMV
- 111: conformal coated blind micro via (BMV)
- 112: stacked BMV
- 113: etch resist
- 114: inner layer pad with opening for BMV
- 115: outer layer contact pad

### Detailed Description of the Invention

The invention provides a method of forming a solder deposit on a substrate by electroplating a tin or tin alloy layer. The process is particularly suitable for fabricating solder bumps on a circuit board, which is able to form solder bumps with good plating uniformity. The method is in more detail described below. The figures shown herein are simply illustrative of the process. The figures are not drawn to scale, i.e. they do not reflect the actual dimensions or features of the various layers in the chip package structure. Like numbers refer to like elements throughout the description.

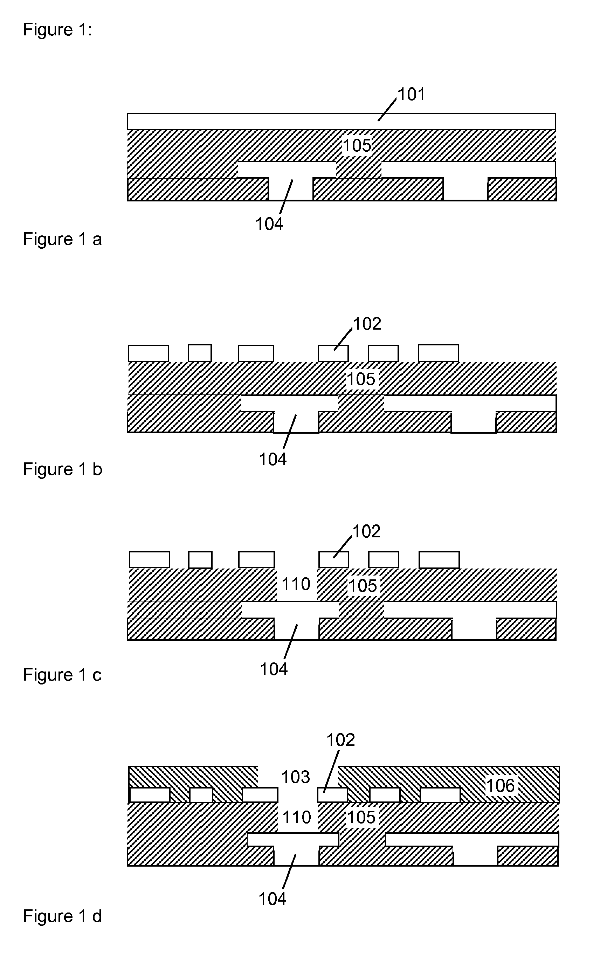

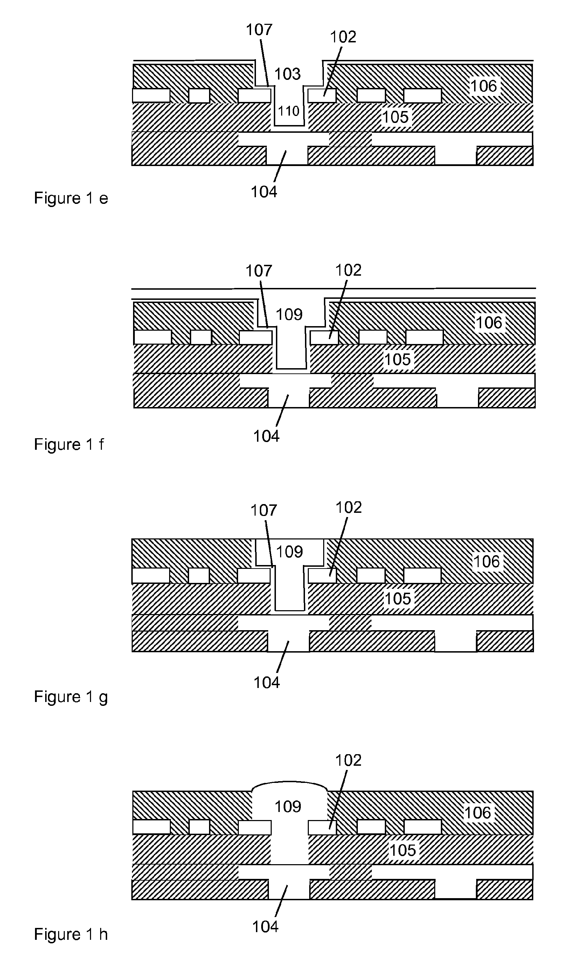

Now referring to FIG. 1 a, in accordance with a preferred embodiment of the present invention, there is provided a non-conductive substrate 105, which has contact inner layer pads 104 as a contact area embodiment. Said inner layer contact pad 104 is formed typically from a metal material, such as copper. The non-conductive substrate 105 can be a board which may be made of an organic material or a fiber-reinforced organic material or a particle-reinforced organic material, etc., for example, epoxy resin, polyimide, bismeleimide triazine, cyanate ester, polybenzocyclobutene, or glass fiber composite thereof, etc. The non-conductive substrate 105 has a copper layer 101 on one side of its surface. The copper layer 101 has a typical thickness of 15 µm although copper layers 101 having a thickness which ranges from 3 to 35 µm are applicable to the method of the present invention. Especially suitable for manufacturing of high density interconnects are copper layers 101 having a thickness of 3-7 µm. Said copper layers 101 are often used with a thickness of 3 µm, 5 µm or 7 µm.

The at least one copper layer 101 which is attached to at least one surface of a non-conductive substrate 105 is structured i.e., converted to a circuitry by the print and etch method. Therefore, a photo resist is deposited onto said copper layer 101 and patterned using methods known in the art. In one embodiment of the present invention, the surface of the copper layer 101 is treated with a micro etch process in order to enhance the adhesion between the surface of the copper layer 101 and the photo resist. Such micro etch processes for copper surfaces are described for example in W. Jillek, G. Keller "Handbuch der Leiterplattentechnik Band 4", E. G. Leuze Verlag Bad Saulgau, 1st Ed. 2003, p. 132. Typical micro etch processes comprise treatment of copper surfaces with persulfates and sulphuric acid or with a composition comprising hydrogen peroxide and sulphuric acid.

Optionally, the surface of the copper layer 101 is subjected to a mechanical treatment prior to the deposition of a photo resist to increase adhesion of a photo resist deposited later on onto the copper layer 101. Such mechanical treatments are known in the art and include brushing and pumicing.

Said chemical and mechanical procedures for increasing adhesion between the surface of a copper layer 101 and a photo resist layer can also be combined.

Either, liquid and dry film photo resists can be applied in order to convert a copper layer 101 into a structured copper layer 102. Typical photo resist materials and procedures to deposit, illuminate and develop them are known in the art. In one embodiment of the present invention, a dry film photo resist is used to provide the circuitry pattern onto the copper layer 101. In another embodiment, a liquid photo resist is used for the same purpose as a dry film photo resist.

The copper layer 101 coated with a patterned photo resist is contacted with an etching composition to remove all copper from those parts of the copper layer 101 which are not coated with the photo resist, leading to a structured copper layer 102. For this purpose different etching compositions can be applied. In one embodiment, an acidic etching composition comprising an acid, a peroxide and CuCl₂ is used. In another embodiment, an alkaline etching composition comprising ammonia and CuCl₂ is used

The photo resist is removed from the non-conductive substrate 105 by conventional resist stripping methods wherein the resist coated substrate is contacted with an alkaline aqueous solution. The temperature of said stripping treatment is held typically between 50 °C and 55 °C. Said aqueous solution is usually sprayed onto the non-conductive substrate 105 having a photo resist layer.

A solder mask layer 106 is deposited on the surface of said non-conductive substrate 105, before an opening 110 is formed, to protect the structured copper layer 102 and provide insulation.

In another embodiment of the present invention, a solder mask layer 106 is deposited onto the structured copper layer 102 and the adjacent surface of the non-conducting substrate 105 after an opening 110 is formed (Figure 1 d).

In one embodiment of the invention the solder mask layer 106 is a permanent solder mask and remains attached to the structured copper layer 102 and the surface of the non-conductive substrate 105 after manufacturing of the printed circuit board.

The solder mask layer 106 is deposited onto the surface of the non-conductive substrate 105 and the structured copper layer 102 by known techniques. Examples applicable to the present invention are screen printing and/or photo lithographic processes. Various types of solder masks can be used in accordance with the present invention: UV-hardening solder masks, thermal curable two-component solder masks and photo imageable solder masks.

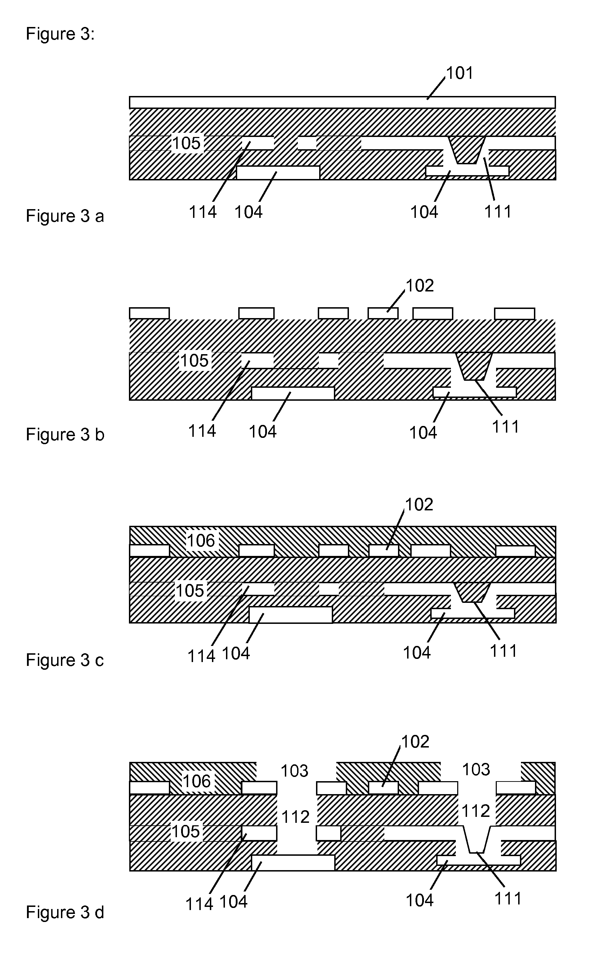

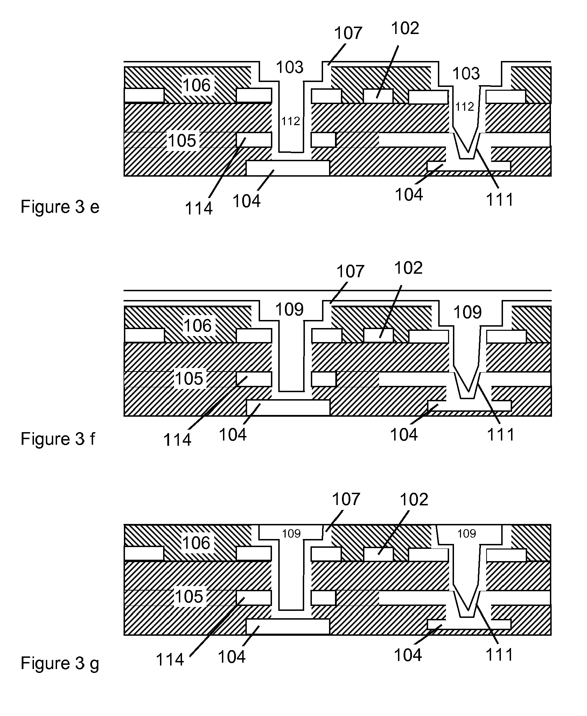

Next, a stacked blind micro via 112 and a solder resist opening 103 for the at least one inner layer contact pad 104 is formed (Figure 3 d). Both mechanical and laser drilling can be applied for this purpose. Laser drilling is the preferred method for the formation of an opening 110, a stacked blind micro via 112 and solder resist openings 103 having a diameter of ≤ 150 µm. Either UV type or CO₂ type laser drilling methods are applicable to the invention.

In one embodiment of the invention openings 110 are drilled after deposition of the solder mask layer 106 contrary as shown in Figure 1 c, i.e., material of the non-conductive substrate 105 is removed by laser drilling thereafter. In another embodiment of the present invention an opening 110 and a stacked blind micro via 112 are drilled through the solder mask layer 106 deposited before drilling and the non-conductive substrate 105 as shown in Figure 3 d.

In the next step the laser drilled opening 110, stacked blind micro via 112 and solder resist opening 103 which expose the inner layer contact pad 104 have to be cleaned and conditioned for subsequent process steps. Methods known in the art like desmear processes are applicable to the method of the present invention.

Smear is related to polymer material residues inside a drilled opening 110 derived from non-conductive substrate material, solder mask and photo resist and is caused by effect of heat during drilling. The smear must be removed prior to metallization of said hole to archive a reliable adhesion of the first metallization layer and the dielectric material and/or to guarantee a reliable copper/copper interconnection.

Said smear can be removed for example by plasma techniques using tetrafluoromethane or a nitrogen/oxygen mixture in a high electrical power field. Plasma techniques are especially applied for base materials like Teflon^{®} and polyimide in a batch process mode.

In one embodiment of the present invention, the desmear process is an alkaline permanganate treatment wherein the plastic material smear from laser drilled opening 110, stacked blind micro via 112 and solder resist opening 103 is removed with a three step process comprising a) swelling of the plastic material in a e.g., butylglycol-based swelling agent, b) permanganate etching which leads to a removal of smear and other residues from plastic material and c) a reducing process wherein breakdown products generated during permanganate etching are removed and the substrate surface inside a hole is further cleaned and conditioned. Said reducing step c) is usually carried out with H₂O₂ based compositions. Optionally a further process step is added in order to clean glass particles and/or glass filaments present in some types of substrate materials.

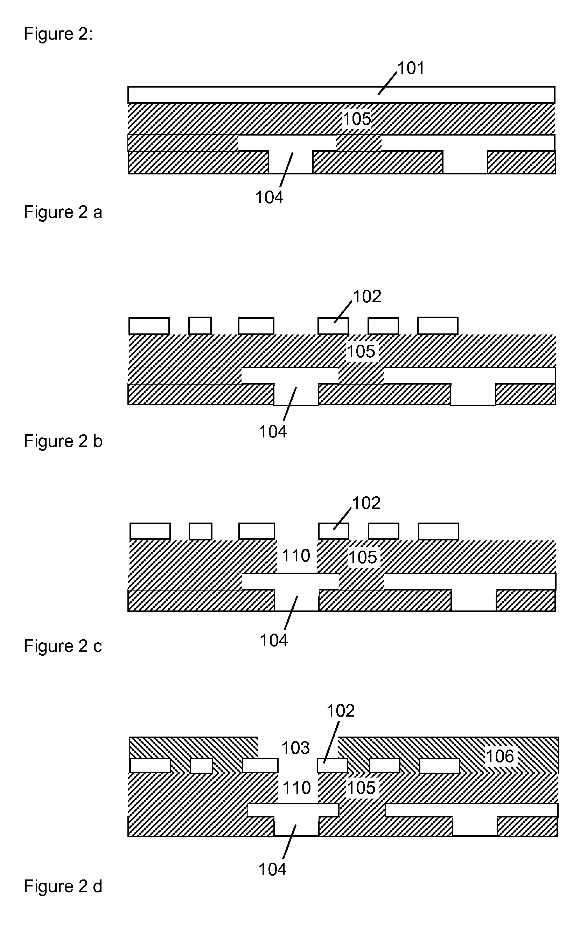

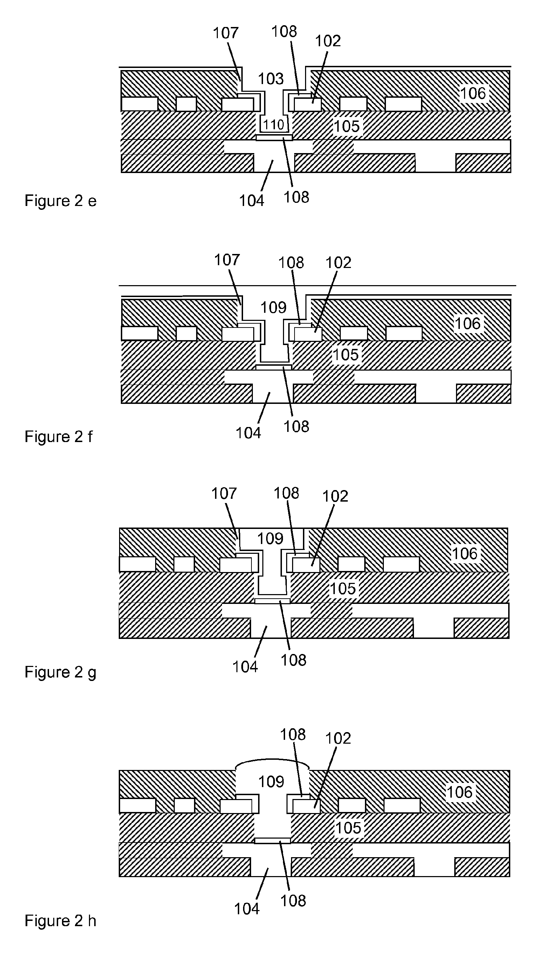

Optionally, a barrier layer 108 is formed on the inner layer contact pad 104 (Figure 2 e). The barrier layer 108 can be an adhesive layer of nickel, a nickel alloy or a protective layer of gold. Said barrier layer 108 may also be made of nickel, nickel-phosphor, palladium, palladium-phosphor, silver, tin, nickel/palladium, chromium/titanium, palladium/gold, or nickel/palladium/gold, etc., which can be made by electoplating, electroless plating, immersion, or physical vapor deposition, etc.

In order to fabricate a solder deposit containing a tin or tin alloy by electroplating on a non-conductive surface, a conductive seed layer formed on the non-conductive surface is required to initiate the electroplating. Such seed layer 107 is depicted in Fig. 1 e. In general, the seed layer is for example formed by electroless deposition in the conventional manufacturing industry of non-conductive surfaces and well known in the art.

According to the present invention the conductive seed layer is deposited over the entire surface of the non-conductive substrate 105 including the inner layer contact pad area 104, the opening 110, the stacked blind micro via 112 and the solder mask area 103.

The seed metal layer is electrically conductive, provides adhesion, permits the exposed portions of its upper surface to be electroplated, and can prevent migration of the subsequent solder deposit metal to the underlying metal of the contact area. Alternatively, the seed metal layer may be composed of two metal layers. An example for the second metal is copper, since it provides a suitable surface for subsequent electroplating.

The non-conductive substrates can be activated by various methods which are described, for example, in Handbuch der Leiterplattentechnik, Vol. 4, 2003, pages 292 to 300. These processes involve the formation of a conductive layer comprising carbon particles, Pd-ions, Pd colloids or conductive polymers. Processes involving the use of carbon particles have been developed by the company "Electrochemicals" and are marketed, for example, under the trade name "Shadow". Another process is known in the art as the "black hole" process which has been developed by the company MacDermid. Processes involving the use of palladium ions have been developed by the companies Shipley Ronal and Atotech and are known, for example, under the trade name_Noviganth^{®}.

Processes involving the use of palladium colloids have been developed by the companies Shipley Ronal and Atotech and are known, for example, under the trade names "Crimson", "Conductron" and "Neopact", respectively.

Processes involving the use of conductive polymers have been developed by the companies OMI Enthone and Atotech and are known, for example, under the trade names "DMSE", "Seleo CP" and "Compact CP", respectively.

Some of these processes are described in the patent literature and examples are given below:
European patent EP 0 616 053 describes a process for applying a metal coating to a non-conductive substrate (without an electroless coating) comprising:
   a. contacting said substrate with an activator comprising a noble metal/Group IVA metal sol to obtain a treated substrate;
   b. contacting said treated substrate with a self accelerating and replenishing immersion metal composition having a pH above 11 to pH 13 comprising a solution of;
      (i) a Cu(II), Ag, Au or Ni soluble metal salt or mixtures thereof,
      (ii) a Group IA metal hydroxide,
      (iii) a complexing agent comprising an organic material having a cumulative formation constant log K of from 0.73 to 21.95 for an ion of the metal of said metal salt.

This process results in a thin conductive layer which can be used for subsequent electrocoating. This process is known in the art as the "Connect" process.

United States patent 5,503,877 describes the metallisation of non-conductive substrates involving the use of complex compounds for the generation of metal seeds on a non-metallic substrate. These metal seeds provide for sufficient conductivity for subsequent electroplating. This process is known in the art as the so-called "Neoganth" process.

United States patent 5,693,209 relates to a process for metallisation of a non-conductive substrate involving the use of conductive pyrrole polymers. The process is known in the art as the "Compact CP" process.

European patent 1 390 568 B1 also relates to direct electrolytic metallisation of non-conductive substrates. It involves the use of conductive polymers to obtain a conductive layer for subsequent electrocoating. The conductive polymers have thiophene units. The process is known in the art as the "Seleo CP" process.

Finally, the non-conductive substrate can also be activated with a colloidal or an ionogenic palladium ion containing solution, methods for which are described, for example, in Handbuch der Leiterplattentechnik, Vol. 4, 2003, pages 307 to 311.

Subsequent electroless plating of a thin intermediate metal coating can optionally been carried out in order to enhance the conductive seed layer. With assistance of the seed layer, electroplating of the solder deposit according to the present invention can then be carried out.

According to the present invention, said conductive seed layer 107 may be made of a metal or an alloy or made of multilayer of metals, such as copper, tin, nickel, cobalt, tin-lead alloy, chromium-copper alloy, titanium/nickel (bi-metal), tin/copper, chromium/chromium-copper alloy/copper, copper/nickel/phosphor alloy, or nickel/tin/copper multilayer. Copper is preferred as a seed layer.

In accordance with a preferred embodiment of the present invention, said seed layer 107 can also be formed by an electroless plating method, wherein the catalytic metal does not use noble metal but uses copper as the catalytic metal. The typical examples for forming such a catalytic copper on a non-conductive surface can be found in the U.S. Pat. Nos. 3,993,491 and 3,993,848.

The thickness of said seed layer 107 preferably is less than 0.1 millimeter and more preferably between 0.0001 millimeter and 0.005 millimeter. Depending on the solubility of said seed layer 107 in the solder material, said seed layer 107 can either completely dissolve into the solder deposit or still at least partially exist after the reflow process.

A thinner said seed layer 107 is preferred, since the thinner seed layer can be removed sooner in the etching solution, the time required for said non-conductive substrate 105 immersed in an etching solution could be shortened. In such a case, the damages to said solder mask layer 106 by said etching solution will be lowered down to an acceptable low level.

It is an advantage of the method of the present invention that no resist layer needs to be applied on selective areas of the substrate surface prior to electroplating the solder deposit.

Referring now to Fig. 1 f a solder material layer 109 containing tin or tin alloy is then formed on the conductive seed layer 107.

In accordance with a preferred embodiment of the present invention, said solder material 109 is a tin or tin alloy made by the mixture of tin and the elements selected from the group consisting of lead, silver, copper, bismuth, antimony, zinc, nickel, aluminum, magnesium, indium, tellurium, and gallium.

Tin and tin alloy plating baths are known in the art. Commonly used tin or tin alloy plating bath compositions and process parameters for plating are described in the following.

Among other components of the bath may be added a source of Sn²⁺ ions, an anti-oxidant, and a surfactant.

The source of Sn²⁺ ions may be a soluble tin-containing anode, or, where an insoluble anode is used, a soluble Sn²⁺ ion source. Tin methane sulfonic acid, Sn(MSA)₂, is a preferred source of Sn²⁺ ions because of its high solubility. Typically, the concentration of the source of Sn²⁺ ions is sufficient to provide between about 10 g/l and about 200 g/l of Sn²⁺ ions into the bath, preferably between about 15 g/l and about 95 g/l, more preferably between about 40 g/l and about 60 g/l. For example, Sn(MSA)₂ may be added to provide between about 30 g/l and about 60 g/l Sn²⁺ ions to the plating bath.

A preferred alloy is tin silver alloy. In such case the plating bath additionally contains a soluble silver salt, commonly used are nitrate, acetate, and preferably methane sulfonate. Typically, the concentration of the source of Ag⁺ ions is sufficient to provide between about 0.01 g/l and about 1.5 g/l of Ag⁺ ions into the bath, preferably between about 0.3 g/l and about 0.7 g/l, more preferably between about 0.4 g/l and about 0.6 g/l. For example, Ag(MSA) may be added to provide between about 0.2 g/l and about 1.0 g/l Ag⁺ ions to the plating bath.

Anti-oxidants may be added to the baths of the present invention to stabilize the bath against oxidation of Sn²⁺ ions in solution. Preferred anti-oxidants such as hydroquinone, catechol, and any of the hydroxyl, dihydroxyl, or trihydroxyl benzoic acids may be added in a concentration between about 0.1 g/l and about 10 g/l, preferably between about 0.5 g/l and about 3 g/l. For example, hydroquinone may be added to the bath at a concentration of about 2 g/l.

Surfactants may be added to promote wetting of the substrate. The surfactant seems to serve as a mild deposition inhibitor which can suppress three-dimensional growth to an extent, thereby improving morphology and topography of the film. It can also help to refine the grain size, which yields a more uniform bump. Exemplary anionic surfactants include alkyl phosphonates, alkyl ether phosphates, alkyl sulfates, alkyl ether sulfates, alkyl sulfonates, alkyl ether sulfonates, carboxylic acid ethers, carboxylic acid esters, alkyl aryl sulfonates, aryl alkylether sulfonates, aryl sulfonates, and sulfosuccinates.

The electrolytic plating bath of the present invention preferably has an acidic pH to inhibit anodic passivation, achieve better cathodic efficiency, and achieve a more ductile deposit. Accordingly, the bath pH is preferably between about 0 and about 3. In the preferred embodiment the pH of the bath is 0. Accordingly, the preferred acidic pH can be achieved using nitric acid, acetic acid, and methane sulfonic acid. In one preferred embodiment, the acid is methane sulfonic acid. The concentration of the acid is preferably between about 50 g/l and about 200 g/l, more preferably between about 70 g/l and about 120 g/l. For example, between about 50 g/l and about 160 g/l methane sulfonic acid can be added to the electroplating bath to achieve a bath of pH 0 and act as the conductive electrolyte.

Typical bath compositions are for example disclosed in: Jordan: The Electrodeposition of Tin and its Alloys, 1995, p. 71-84.

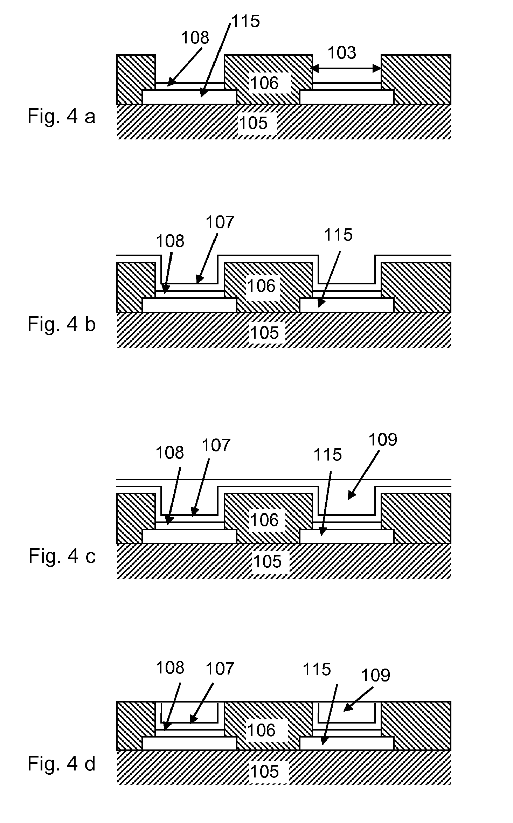

The plating of tin and tin alloys for solder depot plating can be performed by direct current (DC) or pulse plating. Pulse plating techniques are particularly suitable to fill structures of the present invention as shown in Figs. 1 - 11. The advantages of pulse plating are better surface distribution uniformity and improved crystal structures with tin deposits possessing finer grain sizes and therefore better solderability properties. Also, higher applicable current density and therefore higher throughput can be obtained by pulse plating compared to DC plating.

Generally, current pulses at an effective current density of 1 - 20 A/dm² can be applied. Alternatively, operating of the bath with DC at a current density of 0.3 - 5 A/dm² can be performed.

For example, applying a tin pulse plating with a current density of 3 A/dm² yields an average thickness of the tin deposit of 40 µm within 30 min. plating time. The thickness variation on the surface is only +/- 15%. Applying DC plating a maximum current density of only 1 A/dm² can be obtained. Plating time to obtain a thickness of the tin deposit of 40 µm is 86 min. The variation on the surface is +/- 33%, thus much higher than for pulse plating.

Preferred pulse parameters are as follows:
The ratio of the duration of the at least one forward current pulse to the duration of the at least one reverse current pulse is adjusted to at least 1 : 0 - 1 : 7, preferably to at least 1 : 0.5 - 1 : 4 and more preferably to at least 1 : 1 - 1 : 2.5.

The duration of the at least one forward current pulse can be adjusted to preferably at least 5 ms to 1000 ms.

The duration of the at least one reverse current pulse is preferably adjusted to 0.2 - 5 ms at most and most preferably to 0.5 - 1.5 ms.

The peak current density of the at least one forward current pulse at the workpiece is preferably adjusted to a value of 1 - 30 A/dm² at most. Particularly preferable is a peak current density of the at least one forward current pulse at the workpiece of about 2 - 8 A/dm² in horizontal processes. In vertical processes the most preferred peak current density of the at least one forward current pulse at the workpiece is 1 - 5 A/dm² at most.

The peak current density of the at least one reverse current pulse at the work piece will preferably be adjusted to a value of 0 - 60 A/dm². Particularly preferred is a peak current density of the at least one reverse current pulse at the workpiece of about 0 - 20 A/dm² in horizontal processes. In vertical processes the most preferred peak current density of the at least one forward current pulse at the workpiece is 0 - 12 A/dm² at most.

The openings in the structures according to the Figs. 1 - 14 denoted SRO (solder resist opening 103) preferably have a dimension of about 5 - 1.000 µm, preferably of about 10 - 500 µm and even more preferred 20 - 100 µm.

The height of the SROs varies between 5 - 250 µm, preferably of about 10 - 50 µm. The distance of the center points of adjacent contacts areas is denoted as pitch and ranges from 90 - 300 µm for IC substrates, and from 150 - 1.000 µm for printed circuits.

Since also the solder mask layer 106 is covered by a conductive seed layer 107 plating of the solder deposit 109 is also on this layer. The thickness of such a solder deposit layer 109 should preferably not exceed 0.5 - 10 µm and more preferred not exceed 2 - 6 µm.

Referring to Fig 1 g, the solder deposit 109 as well as the conductive seed layer 107 is being removed from the solder mask layer 106. The removal preferably is performed by chemical etching an amount of the solder material layer containing tin or tin alloy sufficient to remove the solder deposit layer 109 and the conductive seed layer 107 from the solder mask layer area 106 leaving a solder material layer on the at least one contact area. The etching of tin and tin alloys, also known as stripping, can be performed electrolytically or chemically. Also, mechanical polishing may be applied alone or in combination with electrolytical or chemical stripping to remove the solder deposit layer 109 and the conductive seed layer 107.

Generally the tin or tin alloy solder deposit 109 and the conductive seed layer 107 can be removed in a single etching step with the same etching solution. In some cases it may be advantageous, however, to apply different etching solutions for removing first the solder deposit layer 109 on the solder mask area 106 and thereafter the conductive seed layer 107. Suitable etching solutions can be chosen applying routine experiments.

Typical etching or stripping compositions are for example disclosed in: Jordan: The Electrodeposition of Tin and its Alloys, 1995, p. 373-377.

During electrolytic stripping methods tin or its alloys are anodically dissolved in a 10 wt.-% NaOH solution at 70 - 90 °C.

Chemical stripping generally is performed in solutions containing a strong base like NaOH (about 10 wt.-%) at elevated temperatures of 70 - 90 °C. Organic additives, particularly nitroaromtaic compounds like p-nitrophenol, may be added to the solution.

Alternatively, chemical stripping can be performed in the following solutions:
- hydrogen peroxide, often with added fluoride,
- systems based on nitric acid and nitrates, 5 - 40 wt.-% of nitrate,
- systems based on HCl / copper chloride, containing 5 - 20 wt.-% HCl with an initial concentration of 2.5 mg/l copper chloride.

Optionally, an additional layer of a metal is deposited onto the solder deposit after excess solder material is etched away. The metal is deposited by an electroless metal plating process and is selected from the group consisting of lead, silver, copper, bismuth, antimony, zinc, nickel, aluminium, magnesium, indium, tellurium, gold and gallium. Said electroless metal plating process includes immersion plating and autocatalytic plating. Processes and compositions for electroless deposition of lead, silver, copper, bismuth, antimony, zinc, nickel, aluminium, magnesium, indium, tellurium and gallium are known in the art and can be adapted to the present invention without any further modification. The preferred metals for electroless metal plating onto the solder deposit layer 109 are silver, copper, nickel, gold and palladium

While this process sequence has been described in detail for a substrate according to Fig. 1 it is not limited to such and may be applied to all kind of substrates. Some additional preferred embodiments of the present invention which can be treated accordingly are shown in Figs. 2 - 12.

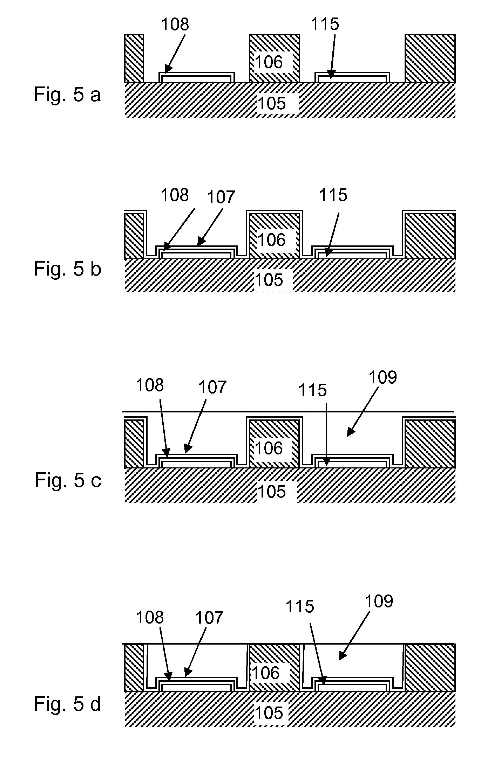

According to the present invention, said solder mask layer 106 is not limited to cover a portion of said inner layer contact pad 104 surface. As shown in Fig. 5, said solder mask layer 106 is deposited on the surface of said non-conductive surface 105 but does not cover any portion of said outer layer contact pad 115 surface. In turn, said conductive seed layer 107 is formed. Subsequently, the solder deposit layer 109 is formed in said opening covering the outer layer contact pad 115 as well as the area of the non-conductive surface 105. Such structure is referred to as non-solder mask defined pad substrate.

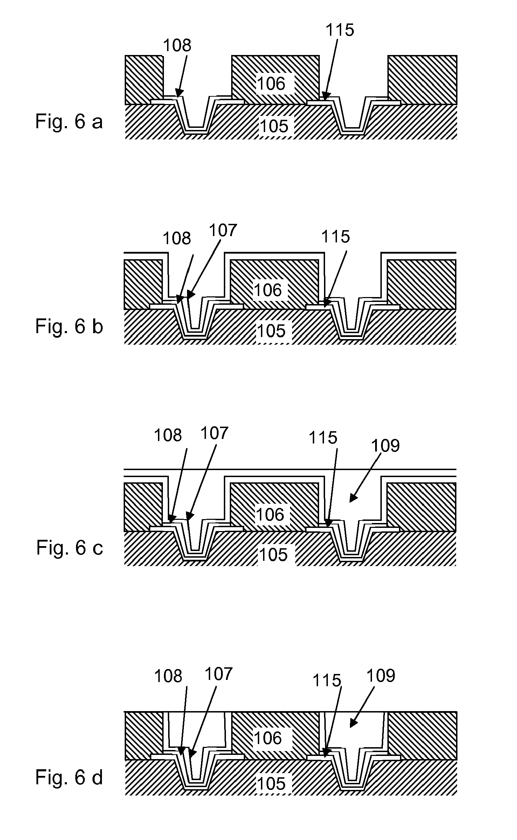

According to the present invention, said outer layer contact pad 115 is not limited to a flat structure. As shown in Fig. 6, said outer layer contact pad 115 can be part of a via or trench which is filled with the solder deposit 109. Vias and trenches preferably have a depth of 5 - 250 µm and a width of 5 - 200 µm.

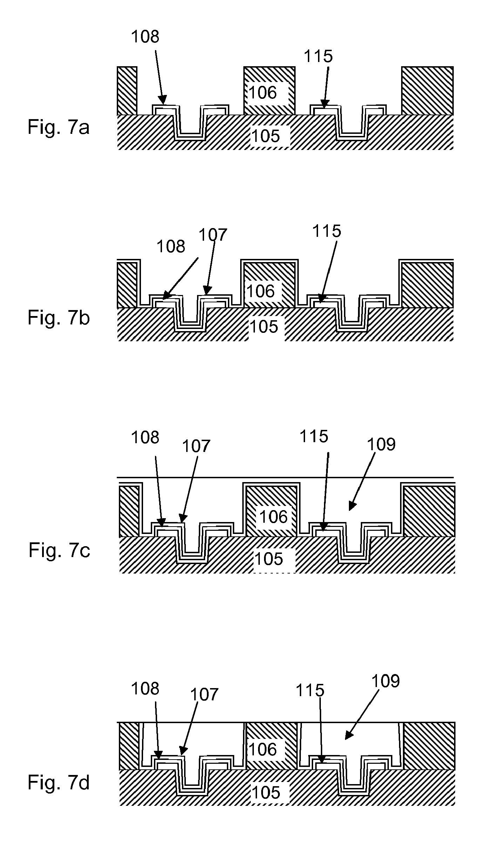

Such structure can also be a non-solder mask defined pad substrate as shown in Fig. 7.

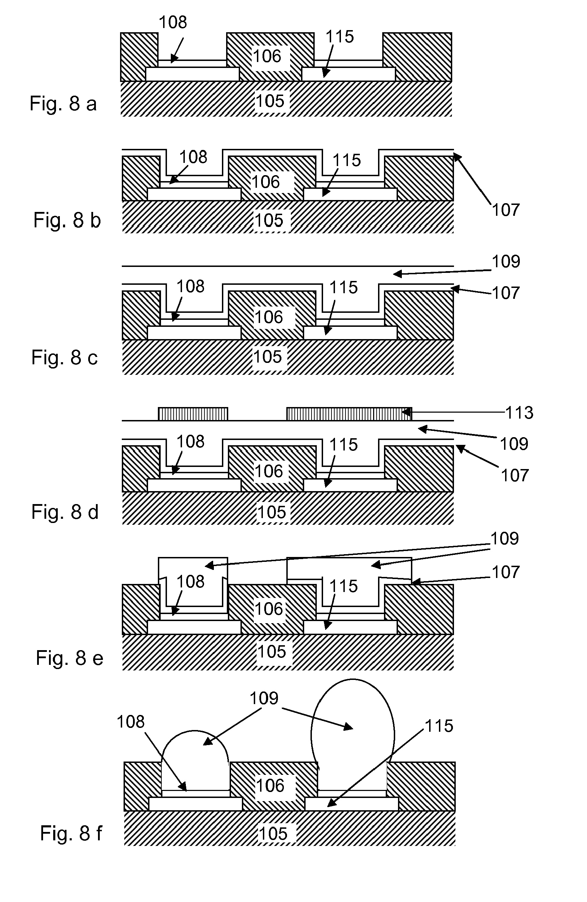

According to the present invention, the solder deposit layer 109 is not limited to the openings but can also extend above the openings as shown in Fig. 8. For this embodiment an etch resist 113 is applied onto the solder deposit layer 109 on at least the surface area overlying the at least one contact pad 104 as shown in Fig. 8 d. The solder deposit layer 109 as well as the conductive layer 107 is etched away in an amount sufficient to remove both the solder deposit layer and the conductive layer from the solder mask layer 106 leaving a solder deposit layer on the at least one contact pad area. Thereafter the etch resist is being removed. Fig. 8 f is an example of the solder deposit 109 being a solder bump after a reflow step.

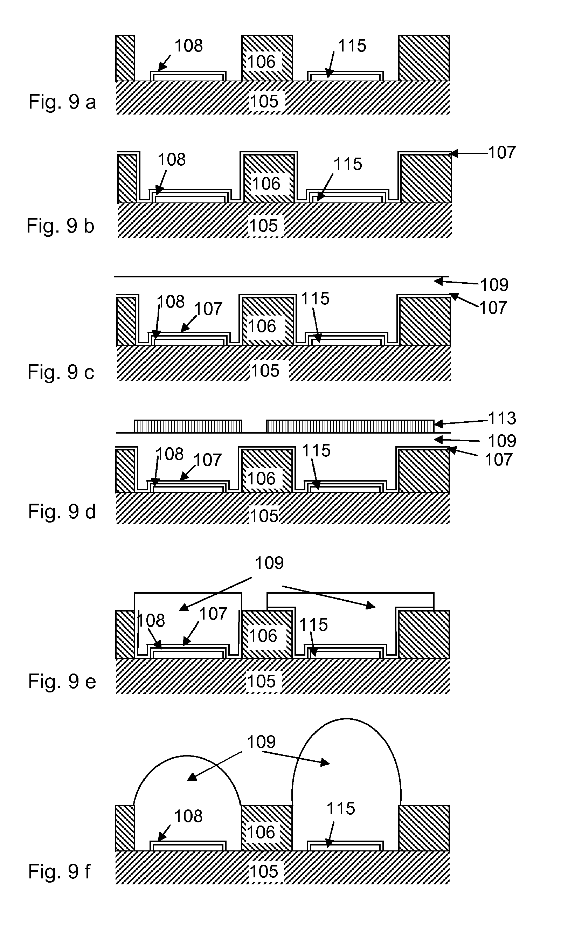

Fig. 9 is an example for a solder bump embodiment like shown in Fig. 8 possessing a non-solder mask defined outer layer contact pad 115.

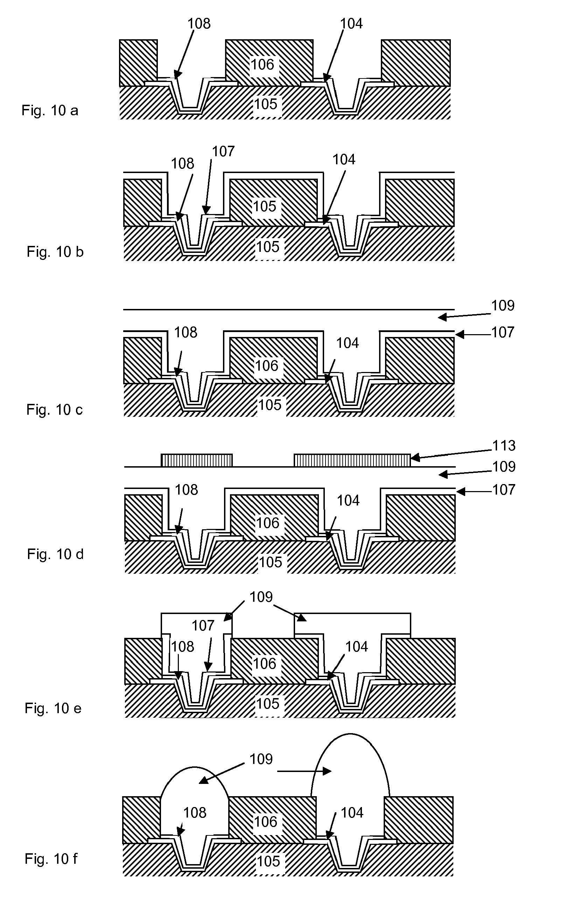

Fig. 10 is an example for a solder bump embodiment wherein the outer layer contact pad 115 is part of a via or trench.

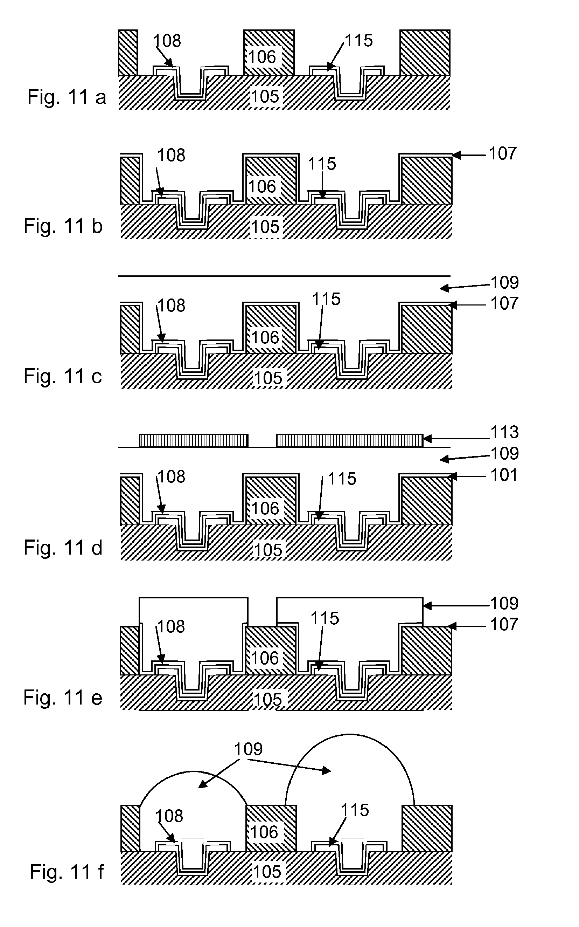

Fig. 11 is an example for a solder bump embodiment wherein the outer layer contact pad 115 is part of a via or trench and the outer layer contact pad 115 is non-solder mask defined.

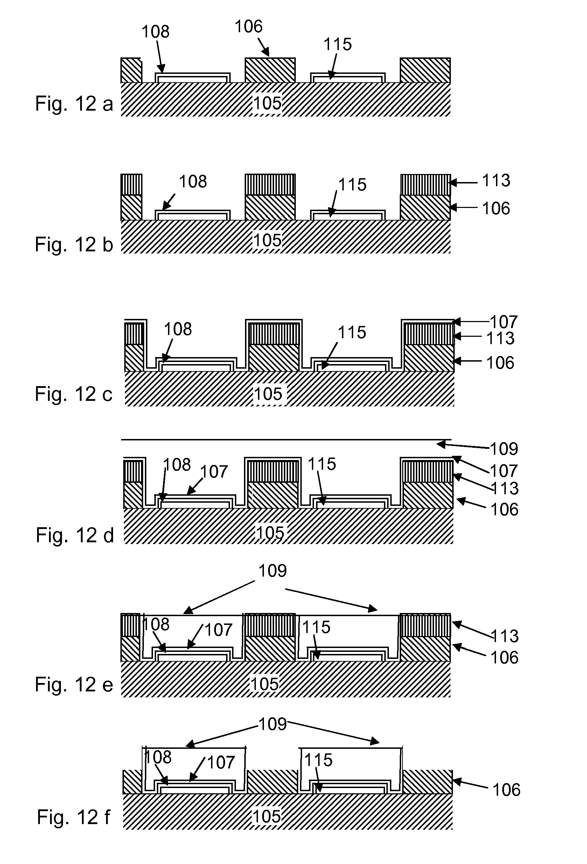

Fig 12. is an example for a non-solder mask defined pad with individual heights of the electroplated solder material layer applying an additional resist. In this embodiment an additional resist 113 is applied on the horizontal surface area of the solder mask 106. Such resist preferably is not applied on the non-conductive substrate area 105. The purpose of adding additional resist is to increase the amount of solder deposit on the substrate. As becomes apparent from Fig. 11 application of an additional resist layer 113 on top of the solder mask layer 106 does not alter the overall plating sequence and particularly does not affect the benefits of the present invention.

In accordance with a preferred embodiment of the present invention, said solder bumps 109 formed from the solder deposit 109 according to Figs. 8 - 12 can be applied for forming flip chip joints. At a reflow temperature, a flip chip joint can be formed.

In accordance with a preferred embodiment of the present invention, said electroplate solder bumps can be applied for forming flip chip joints with metal bumps on the IC chip. At a reflow temperature, a flip chip joint can be formed.

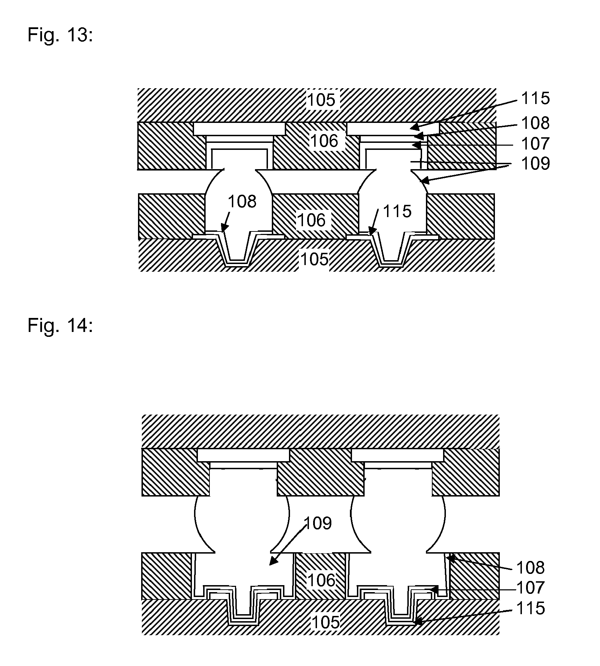

Fig. 13 is an example of a joining process between two substrates according to a preferred embodiment of the present invention, e.g. of a IC-substrate (top) with a printed circuit board (bottom). At a reflow temperature, a BGA or flip chip-joint can be formed.

Fig. 14 is another example of a joining process between two substrates according to a preferred embodiment of the present invention, e.g. of a IC-substrate (top) with a printed circuit board (bottom). The solder bump has been pre-balled prior to the joining process by a reflow process.

At a reflow temperature, a flip chip or BGA joint can be formed.

In accordance with a preferred embodiment of the present invention, said electroplate solder bumps can be applied for forming flip chip joints and board to board solder joints.

The solder bumps can be any shape, such as stud bumps, ball bumps, columnar bumps, or others.

The following example further illustrates the present invention.

### Example

An IC substrate is used having a copper layer 101 and an inner layer contact pad structure according to Fig. 1 a.,

The plating sequence is according to Fig. 1.

The IC substrate is first cleaned with standard procedures and then micro etched in an aqueous composition comprising hydrogen peroxide and sulphuric acid. Next, a dry film photo resist (PM 250, DuPont) is laminated onto the copper layer 101. The dry film photo resist is patterned in a standard procedure. The structured copper layer 102 is formed by etching the copper layer 101 with a etching composition comprising 200 ml/l HCl (32 %) and 160 g/l CuCl₂·2H₂O. For this purpose the substrate is contacted with the etching composition in a horizontal set-up having an array of nozzles at a temperature of 45 °C. The contact time is about 30 s. After formation of the structured copper layer 102 the patterned dry film photo resist is removed with an aqueous solution of 2 wt.-% potassium carbonate. In the next step an opening 110 is drilled with a UV-laser.

Smear inside the opening 110 is removed by a desmear process, i.e., an alkaline permanganate treatment comprising a) swelling of the plastic material in a butylglycol-based swelling agent, b) permanganate etching with a potassium permanganate based composition and c) reducing with a reductor solution comprising hydrogen peroxide.

Next, a solder mask having a thickness of 25 µm (Lackwerke Peters, ELPEMER SD 2467 SG-DG (525)) is deposited onto the structured copper layer 102 and the adjacent surface of the non-conductive substrate 105. The solder mask is photo structured in order to expose the before drilled opening 110.

A conductive seed layer 107 of copper is formed on the entire substrate surface. For this the surface is first contacted with an acidic solution containing ionogenic palladium and then with a solution for chemical copper deposition.

Thereafter, a tin solder deposit 109 is plated on the conductive layer from a bath containing:
45 g/l Sn²⁺ as Sn(MSA)₂, 60 ml/l MSA (70% solution), 2 g/l Hydroquinone, 7.0 g/l of Lugalvan BNO12 and 100 mg/l benzal acetone.

The pH of the bath is 0, the temperature 25 °C. Plating is for 7 min. Pulse plating is used applying the following parameters:
Average current density of the forward current pulse: 2 A/dm²;
Duration of the forward current pulse: 20 ms;
Average current density of the reverse current pulse: 0 A/dm² (no reverse pulse, only pause pulse);
Duration of the reverse current pulse: 4 ms.

The openings (SRO) according to Fig. 1 are completely filled with tin solder deposit without any void formation. Additionally, tin has been deposited on the solder mask area 106, the thickness of which is 3 µm (Fig. 1 f).

The tin solder deposit 109 on the solder mask area as well as the conductive seed layer 107 are thereafter removed by treatment in a solution containing 30 vol.-% nitric acid at a temperature of 40 °C for 1 min.

After the etching process tin solder deposit 109 only remains in the opening, while the tin solder deposit 109 as well as the conductive seed layer of copper 107 on the solder mask area 106 have been entirely removed (Fig 1 g). The tin solder deposit shows a very homogenous surface distribution and is whisker free. It is suited to be soldered to a chip or circuit.

## Claims

1. A method of forming a solder deposit on a substrate comprising the following steps:
i) provide a substrate having at least one copper surface 101 and at least one inner layer pad 104,
ii) form a photo resist layer that is placed on the at least one copper surface 101 of the substrate and structure said photo resist layer to a negative image of a circuitry,
iii) etch away the portions of the at least one copper surface 101 which are exposed through the patterned photo resist,
iv) remove the photo resist,
v) form at least one opening 110 to expose the at least one inner layer pad 104,
vi) form a solder mask layer 106 that is placed on the substrate surface and structured to expose the at least one inner layer pad 104,
vii) contact the entire substrate area including the solder mask layer 106 and the at least one inner layer pad 104 with a solution suitable to provide a conductive layer 107 on the substrate surface,
viii) electroplate a solder deposit layer 109 containing a tin or tin alloy onto the conductive layer 107,
ix) etch away an amount of the solder deposit layer 109 containing tin or tin alloy and the conductive layer 107 sufficient to remove both the solder deposit layer 109 and the conductive layer 107 from the solder mask layer 106 area leaving a solder deposit layer 109 on the at least one inner layer pad 104.

2. A method of forming a solder deposit on a substrate comprising the following steps:
i) provide a substrate having at least one copper surface 101 and at least one inner layer pad 104,
ii) form a photo resist layer that is placed on the at least one copper surface 101 of the substrate and structure said photo resist layer to a negative image of a circuitry,
iii) etch away the portions of the at least one copper surface 101 which are exposed through the patterned photo resist,
iv) remove the photo resist,
v) form a solder mask layer 106 that is placed on the substrate surface and structured to expose the at least one inner layer pad 104,
vi) form at least one opening 110 to expose the at least one inner layer pad 104,
vii) contact the entire substrate area including the solder mask layer 106 and the at least one inner layer pad 104 with a solution suitable to provide a conductive layer 107 on the substrate surface,
viii) electroplate a solder deposit layer 109 containing a tin or tin alloy onto the conductive layer 107,
ix) etch away an amount of the solder deposit layer 109 containing tin or tin alloy and the conductive layer 107 sufficient to remove both the solder deposit layer 109 and the conductive layer 107 from the solder mask layer 106 area leaving a solder deposit layer 109 on the at least one inner layer pad 104.

3. Method according to any of the foregoing claims wherein a barrier layer 108 is plated on the at least one inner layer pad 104 between step vi) and vii).

4. Method according to any of the foregoing claims wherein the barrier layer consists of a metal selected from the group consisting of copper, tin, nickel, chromium, titanium, gold, palladium, copper-chromium alloy, tin-lead alloy and any alloy thereof.

5. Method according to any of the foregoing claims wherein the inner layer pad 104 comprises a via or trench.

6. Method according to any of the foregoing claims, wherein the substrate is subjected to a reflow process to reflow the solder deposit layer 109 containing a tin or tin alloy.

7. Method according to any of the foregoing claims wherein the conductive layer 107 is formed by electroless deposition of copper.

8. Method according to any of the foregoing claims wherein the solder deposit layer 109 is a tin alloy made by the mixture of tin and the elements selected from the group consisting of lead, silver, copper, bismuth, antimony, zinc, nickel, aluminium, magnesium, indium, tellurium, nickel, and gallium.

9. Method according to any of the foregoing claims wherein an additional layer of metal is deposited by an electroless metal plating process onto the solder deposit layer 109 after step ix).

10. Method according to claim 10, wherein the metal forming the additional layer of metal is selected from the group consisting of lead, silver, copper, bismuth, antimony, zinc, nickel, aluminium, magnesium, indium, tellurium, gold, and gallium

11. Method according to any of the foregoing claims wherein the substrate is a printed circuit board, an IC substrate or an interposer.
